(19) Europäisches Patentamt
European Patent Office
Office européen des brevets

(11) Veröffentlichungsnummer: **0 052 788**
**B1**

# (12) EUROPÄISCHE PATENTSCHRIFT

(45) Veröffentlichungstag der Patentschrift: **01.08.84**

(51) Int. Cl.³: **G 03 C 1/56**, G 03 C 1/94, G 03 F 1/00 // G03F7/08, G03C5/18

(21) Anmeldenummer: **81109008.3**

(22) Anmeldetag: **27.10.81**

(54) **Lichtempfindliches Gemisch auf Basis von o-Naphthochinondiaziden und daraus hergestelltes lichtempfindliches Kopiermaterial.**

(30) Priorität: **21.11.80 DE 3043967**

(43) Veröffentlichungstag der Anmeldung: **02.06.82 Patentblatt 82/22**

(45) Bekanntmachung des Hinweises auf die Patenterteilung: **01.08.84 Patentblatt 84/31**

(84) Benannte Vertragsstaaten: **AT BE CH DE FR GB LI NL**

(56) Entgegenhaltungen: **Keine**

(73) Patentinhaber: **HOECHST AKTIENGESELLSCHAFT, Postfach 80 03 20, D-6230 Frankfurt am Main 80 (DE)**

(72) Erfinder: **Stahlhofen, Paul, Dr., Leibnizstrasse 18/B, D-6200 Wiesbaden (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 052 788 B1

**Beschreibung**

Die Erfindung betrifft ein positiv arbeitendes lichtempfindliches Gemisch, das ein wasserunlösliches, in wässrigalkalischen Lösungen lösliches oder quellbares harzartiges Bindemittel und als lichtempfindliche Verbindung einen Naphthochinon-(1,2)-diazidsulfonsäureester eines Trihydroxyphenylketons enthält und das insbesondere zur Herstellung von Flachdruckplatten bestimmt ist.

Lichtempfindliche Verbindungen der angegebenen Gattung sind aus der DE-PS 938 233 und der US-PS 3 802 885 bekannt. Es handelt sich hierbei um teilweise oder vollständig mit Naphthochinondiazidsulfonsäuren veresterte Di- oder Trihydroxybenzophenone. Von diesen Verbindungen werden in neuerer Zeit die vollständig veresterten Vertreter bevorzugt, die keine freien phenolischen OH-Gruppen mehr enthalten. Diese Verbindungen weisen eine relativ hohe Lichtempfindlichkeit auf und ergeben hohe Druckauflagen, sie haben jedoch den Nachteil einer für manche Zwecke zu geringen Löslichkeit in den üblicherweise zur Beschichtung von Druckplatten verwendeten organischen Lösungsmitteln, wie Glykolpartialethern oder Carbonsäurealkylestern wie Butylacetat. Sie ergeben ferner in Kombination mit den bevorzugten, in wässrigalkalischen Lösungsmitteln löslichen Bindemitteln, z.B. Novolaken, Schichten, die in unbelichtetem Zustand gegenüber den gebräuchlichen alkalischen Entwicklerlösungen nicht genügend resistent sind. Diese Schichten werden auch während des Drucks in Offsetdruckmaschinen bei Verwendung von Alkohol enthaltenden Feuchtwässern in gewissem Masse angegriffen und sind auch empfindlich gegenüber Benzinkohlenwasserstoffen, wie sie häufig während des Drucks zum Abwaschen der oleophilen Druckfarbe von der Platte verwendet werden.

Aus der DE-PS1 118 606 sind Naphthochinondiazidsulfonsäureester von phenolischen Verbindungen mit etwas anderem Grundgerüst, z.B. von Derivaten des Diphenylmethans, bekannt. Auch diese Ester enthalten stets mindestens eine freie Hydroxygruppe.

Aufgabe der Erfindung war es, ein lichtempfindliches, positiv arbeitendes Gemisch mit einem neuen 1,2-Naphthochinon-2-diazidsulfonsäureester als lichtempfindliche Verbindung vorzuschlagen, das in seinen druck- und kopiertechnischen Eigenschaften mit den besten bisher bekannten Gemischen dieser Art mindestens vergleichbar ist, das aber eine höhere Resistenz gegenüber wässrigalkalischen Entwicklerlösungen und den beim Offsetdruck verwendeten organischen Lösungsmitteln sowie eine härtere Gradation aufweist.

Gegenstand der Erfindung ist ein lichtempfindliches Gemisch, das als lichtempfindliche Verbindung einen Naphthochinon-(1,2)-diazid-(2)-4- oder -5-sulfonsäureester eines Trihydroxyphenylketons und ein wasserunlösliches, in wässrig-alkalischen Lösungen lösliches oder mindestens quellbares harzartiges Bindemittel enthält.

Das erfindungsgemässe Gemisch ist dadurch gekennzeichnet, dass es einen Naphthochinondiazidsulfonsäureester der allgemeinen Formel I

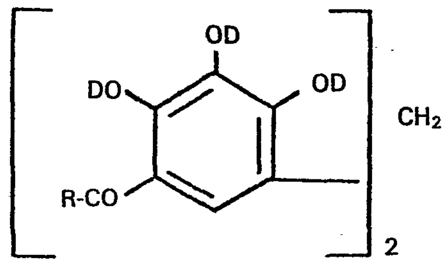

I

enthält, worin

D einen Naphthochinon-(1,2)-diazid-(2)-4-sulfonyl- oder einen Naphthochinon-(1,2)-diazid-(2)-5-sulfonylrest und

R einen Alkyl- oder Arylrest

bedeuten.

Von den Verbindungen der Formel I werden diejenigen, in denen D eine Naphthochinon-(1,2)-diazid-(2)-5-sulfonsäureestergruppe bedeutet, bevorzugt.

Die Alkylreste R können geradkettig oder verzweigt sein und gegebenenfalls durch Halogenatome oder Alkoxygruppen substituiert sein. Sie enthalten vorzugsweise 1 bis 20 Kohlenstoffatome. Die Arylreste R sind vorzugsweise einkernig und können durch Alkyl- oder Alkoxygruppen oder Halogenatome substituiert sein. Sie enthalten vorzugsweise 6 bis 10 Kohlenstoffatome. Verbindungen, in denen R ein Aryl-, insbesondere ein Phenylrest ist, werden besonders bevorzugt.

Die erfindungsgemässen Gemische zeichnen sich durch hohe Lichtempfindlichkeit, gute Entwicklerresistenz und gute Haftung auf Druckplattenschichtträgern aus. Sie weisen ferner eine hohe Resistenz gegenüber alkoholhaltigen Feuchtwässern und gegenüber Benzinkohlenwasserstoffen auf.

Die in dem erfindungsgemässen Gemisch enthaltenen Chinondiazide sind neu. Ihre Herstellung erfolgt in Analogie zu bekannten Verfahren durch Veresterung der phenolischen Hydroxygruppen der Grundkörper mit o-Chinondiazidsulfonsäuren oder deren reaktionsfähigen Derivaten, z.B. den Sulfonsäurechloriden.

Die entsprechenden Ausgangsprodukte, die Bis-(5-acyl-2,3,4-trihydroxy-phenyl)-methane erhält man in guter Ausbeute durch Umsetzung der entsprechenden 4-Acyl-pyrogallole mit wässriger Formaldehydlösung (38 Gew.-%) bei 80 - 100°C in Gegenwart von sauren Katalysatoren, wie Salzsäure, Oxalsäure oder p-Toluolsulfonsäure. Falls notwendig, wird zur Auflösung der Verbindungen ein organisches Lösungsmittel, z.B. Alkohol oder Dioxan, zugesetzt.

Einige der so hergestellten Ausgangsprodukte sind in der folgenden Tabelle aufgeführt. Hinter dem Schmelzpunkt ist in Klammern das Lösungsmittel angegeben, aus dem umkristallisiert wurde.

| R | Schmelzpunkt (°C) |
|---|---|
| $C_6H_5$ | 225 (Methanol) |
| $CH_3$ | 252 (Alkohol) |
| $CH_3CH_2$ | 233 (Alkohol) |
| $CH_3CH_2CH_2$ | 180 (Methanol) |
| $CH_3(CH_2)_{16}$ | 138 (Alkohol) |
| $CH_3(CH_2)_4$ | 170 (Methanol) |
| $CH_3(CH_2)_8$ | 146 (Methanol) |

Die Konzentration der neuen Naphthochinondiazidsulfonsäureester in der lichtempfindlichen Schicht kann in relativ weiten Grenzen schwanken. Im allgemeinen liegt der Anteil bei 3 bis 50, vorzugsweise zwischen 7 und 25%, bezogen auf das Gewicht des Feststoffanteils des lichtempfindlichen Gemischs.

Die erfindungsgemässen lichtempfindlichen Gemische enthalten ferner ein polymeres, wasserunlösliches harzartiges Bindemittel, das sich in den für das erfindungsgemässe Gemisch verwendeten Lösungsmitteln löst und in wässrigen Alkalien ebenfalls löslich oder zumindest quellbar ist.

Die bei vielen Positiv-Kopiermaterialien auf Basis von Naphthochinondiaziden bewähren Novolak-Kondensationsharze haben sich als Zusatz auch bei den erfindungsgemässen Gemischen mit den neuen Naphthochinondiazidsulfonsäureestern als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z.B. Kresolen, als Formaldehyd-Kondensationspartner. Als weitere alkalilösliche bzw. in Alkali quellbare Bindemittel sind natürliche Harze, wie Schellack und Kolophonium, und synthetische Harze, wie Mischpolymerisate aus Styrol und Maleinsäureanhydrid oder Mischpolymerisate der Acrylsäure oder Methacrylsäure, insbesondere mit Acryl- oder Methacrylsäureestern, zu nennen.

Die Art und Menge des alkalilöslichen Harzes kann je nach Anwendungszweck verschieden sein; bevorzugt werden Anteile am Gesamtfeststoff zwischen 95 und 50, besonders bevorzugt 90 - 65 Gew.-%. Zusätzlich können noch zahlreiche andere Harze mitverwendet werden, bevorzugt Epoxide und Vinylpolymerisate wie Polyvinylacetate, Polyacrylate, Polyvinylacetale, Polyvinylether, Polyvinylpyrrolidone und die Mischpolymerisate der ihnen zugrundeliegenden Monomeren. Der günstigste Anteil an diesen Harzen richtet sich nach den anwendungstechnischen Erfordernissen und dem Einfluss auf die Entwicklungsbedingungen und beträgt im allgemeinen nicht mehr als 20 Gew.-% vom alkalilöslichen Harz. In geringen Mengen kann das lichtempfindliche Gemisch für spezielle Erfordernisse wie Flexibilität, Haftung, Glanz, Färbung und Farbumschlag usw. ausserdem noch Substanzen wie Polyglykole, Cellulosederivate wie Ethylcellulose, Netzmittel, Farbstoffe, Haftvermittler und feinteilige Pigmente sowie bei Bedarf UV-Absorber enthalten.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemässe Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether von Glykolen, insbesondere Ethylenglykolmonomethylether, werden besonders bevorzugt.

Als Schichtträger für Schichtdicken unter ca. 10 $\mu m$ werden meist Metalle verwendet. Für Offsetdruckplatten können eingesetzt werden: walzblankes, mechanisch oder elektrochemisch aufgerauhtes und ggf. anodisiertes Aluminium, das zudem noch chemisch, z.B. mit Polyvinylphosphonsäure, Silkaten, Phosphaten, Hexafluorosilikaten oder mit hydrolysiertem Tetraethylorthosilikat, vorbehandelt sein kann, ausserdem Mehrmetallplatten z.B. aus Al/Cu/Cr oder aus Messing/Chrom. Für die Herstellung von Hochdruckplatten können die erfindungsgemässen Gemische auf Zink- oder Magnesium-Platten sowie deren handelsübliche mikrokristalline Legierungen für Einstufenätzverfahren aufgetragen werden, ausserdem auf ätzbare Kunststoffe wie Polyoxymethylen. Für Tiefdruck- oder Siebdruckformen eignen sich die erfindungsgemässen Gemische durch ihre gute Haftung und Ätzfestigkeit auf Kupfer- und Nickeloberflächen. Ebenso lassen sich die erfindungsgemässen Gemische als Photoresists in der Leiterplattenfertigung und beim Formteilätzen verwenden.

Für weitere Anwendungen kommen auch andere Träger wie Holz, Papier, Keramik, Textil und andere Metalle in Betracht.

Bevorzugte Träger für dicke Schichten über 10 $\mu m$ sind Kunststoff-Folien, die dann als temporäre Träger für Transferschichten dienen. Dafür und für Farbprüffolien werden Polyesterfolien, z.B. aus Polyethylenterephthalat, bevorzugt. Polyolefinfolien wie Polypropylen sind jedoch ebenfalls geeignet.

Die Beschichtung des Trägermaterials erfolgt in bekannter Weise durch Aufschleudern, Sprühen, Tauchen, Walzen, mittels Breitschlitzdüsen, Rakeln oder durch Giesser-Antrag. Schliesslich kann die Beschichtung von z.B. Leiterplatten, Glas oder Keramik und Silizium-Scheiben auch durch Schichtübertragung von einem temporären Träger erfolgen. Belichtet wird mit den in der Technik üblichen Lichtquellen. Auch das Bestrahlen mit Elektronen oder Lasern stellt eine Möglichkeit zur Bebilderung dar.

Die zum Entwickeln verwendeten wässrig-alkalischen Lösungen abgestufter Alkalität, vorzugsweise mit einem pH im Bereich von 10-14, die auch kleinere Mengen organischer Lösungs- oder Netzmittel enthalten können, entfernen die vom Licht getroffenen Stellen der Kopierschicht und erzeugen so ein positives Abbild der Vorlage.

Bevorzugte Anwendung finden die erfindungsgemässen lichtempfindlichen Gemische bei der Herstellung von Druckformen, d.h. insbesondere Offset-, autotypischen Tiefdruck- und Siebdruckformen, in Kopierlacken und sogenannten Trockenresists.

Die unter Verwendung der neuen Verbindungen hergestellten Druckplatten besitzen eine hohe praktische Lichtempfindlichkeit, sowie eine verbesserte Resistenz gegenüber alkalischen Entwicklern und solchen organischen Lösungsmitteln, wie sie üblicherweise während der Kopierarbeiten oder während des Druckvorgangs an den Druckmaschinen

verwendet werden. Die bevorzugten Verbindungen selbst zeichnen sich durch eine gute Löslichkeit in den üblichen Lösungsmitteln, durch eine starke Oleophilie sowie durch eine gute Verträglichkeit mit den übrigen Bestandteilen der Kopierschicht aus.

Die Erfindung wird anhand der folgenden Beispiele näher erläutert, in denen Gewichtsteile (Gt) und Volumenteile (Vt) im Verhältnis von g zu $cm^3$ stehen. Prozente sind, wenn nichts anderes angegeben ist, Gewichtsprozente.

*Beispiel 1*

Mit einer Lösung von

1,10 Gt des Veresterungsproduktes aus 1 Mol Bis-(5-benzoyl-2,3,4-trihydroxy-phenyl)-methan und 6 Mol Naphthochinon-(1,2)-diazid-(2)-5-sulfonsäurechlorid,
6,00 Gt eines Kresol-Formaldehyd-Novolaks mit einem Erweichungspunkt von 105 bis 120°C,
0,12 Gt 4-(p-Tolylmercapto)-2,5-diethoxy-benzol-diazoniumhexafluorophosphat und
0,06 Gt Kristallviolett (C.I. 42 555) in
40 Gt Ethylenglykolmonomethylether und
50 Gt Tetrahydrofuran

wurde eine elektrochemisch aufgerauhte und anodisierte Aluminiumplatte mit einem Oxidgewicht von 3 $g/m^2$ beschichtet. Der anodisierte Aluminiumträger war vor dem Aufbringen der lichtempfindlichen Kopierschicht mit einer wässrigen Lösung von Polyvinylphosphonsäure behandelt worden, wie es in der DE-PS 1 621 478 beschrieben ist.

Das so hergestellte lichtempfindliche Material mit einem Gewicht der lichtempfindlichen Schicht von 2,30 $g/m^2$ wurde unter einer transparenten Positivvorlage bildmässig belichtet und anschliessend mit der folgenden Lösung entwickelt:

5,3 Gt Natriummetasilikat × 9 Wasser,
3,4 Gt Trinatriumphosphat × 12 Wasser,
0,3 Gt Natriumdihydrogenphosphat (wasserfrei) in
91,0 Gt Wasser.

Durch die Entwicklung wurden die vom Licht getroffenen Anteile der Kopierschicht entfernt, und es blieben die unbelichteten Bildstellen auf dem Schichtträger zurück, so dass eine der Vorlage entsprechende Druckschablone erhalten wurde. Von der so hergestellten Druckform wurden in einer Offsetdruckmaschine etwa 250.000 einwandfreie Drucke erhalten. die Druckschablone zeichnete sich durch eine aufgezeichnete Entwicklerresistenz und Haftung auf der Unterlage aus.

Auffallend gut war ausserdem die Resistenz der Kopierschicht gegenüber bestimmten organischen Lösungsmitteln, z.B. alkoholhaltigen Feuchtwässern oder benzinhaltigen Auswaschmitteln, wie sie während des Druckvorganges an den Druckmaschinen verwendet werden.

In den folgenden Beispielen werden weitere Beschichtungslösungen angegeben, bei denen ähnliche Ergebnisse erhalten wurden. Wenn nicht gesondert vermerkt, entsprechen Herstellung und Verarbeitung der damit erhaltenen Druckplatten den in Beispiel 1 beschriebenen Bedingungen.

*Beispiel 2*

Mit einer Lösung von

1,00 Gt des Veresterungsproduktes aus 1 Mol Bis-(5-acetyl-2,3,4-trihydroxy-phenyl)-methan und 6 Mol Naphthochinon-(1,2)-diazid-(2)-5-sulfonsäurechlorid,
6,10 Gt des in Beispiel angegebenen Novolaks,
0,15 Gt Polyvinylbutyral (69-71% Vinylbutyraleinheiten, ca. 1% Vinylacetateinheiten und 24-27% Vinylalkoholeinheiten),
0,06 Gt Sudangelb GGN (C.I. 11 021) und
0,06 Gt Kristallviolett in
45 Gt Ethylenglykolmonomethylether und
50 Gt Tetrahydrofuran

wurde eine wie in Beispiel 1 beschrieben vorbehandelte Aluminiumplatte beschichtet. Die so hergestellte vorsensibilisierte Druckplatte wurde unter einer transparenten Positiv-Vorlage bildmässig belichtet und mit der im Beispiel 1 angegebenen Lösung entwickelt. Die Entwicklerresistenz der unbelichteten Schichtbereiche sowie die Resistenz gegenüber alkoholhaltigem Feuchtwasser war sehr gut.

Wenn in der Beschichtungslösung der angegebene Naphthochinondiazidsulfonsäureester durch gleiche Mengen der analogen Veresterungsprodukte aus Bis-(5-propionyl-2,3,4-trihydroxy-phenyl)methan oder aus Bis-(5-butyryl-2,3,4-trihydroxy-phenyl)-methan ersetzt wurde, wurden Druckplatten mit ähnlich guten Eigenschaften erhalten.

*Beispiel 3*

Mit einer Lösung von

1,00 Gt des Veresterungsproduktes aus 1 Mol Bis-(5-octadecanoyl-2,3,4-trihydroxy-phenyl)-methan und 6 Mol Naphthochinon-(1,2)-diazid-(2)-5-sulfonsäurechlorid,
6,10 Gt des in Beispiel 1 angegebenen Novolaks,
0,10 Gt Naphthochinon-(1,2)-diazid-(2)-4-sulfonsäurechlorid und
0,06 Gt Kristallviolett in
45 Gt Ethylenglykolmonomethylether und
50 Gt Tetrahydrofuran

wurde eine elektrochemisch aufgerauhte und anodisierte Aluminiumplatte mit einem Oxidgewicht von 3,0 $g/m^2$ beschichtet. Die so hergestellte lichtempfindliche Druckplatte wurde unter einer transparenten Positiv-Vorlage bildmässig belichtet und mit der im Beispiel 1 angegebenen Lösung entwickelt.

Druckplatten mit ähnlichen guten Eigenschaften wurden erhalten, wenn in der Beschichtungslösung die lichtempfindliche Verbindung durch die gleiche Menge des entsprechenden Veresterungsprodukts aus Naphthochinon-(1,2)-diazid-(2)-5-sulfonsäurechlorid und Bis-(5-decanoyl-2,3,4-trihydroxy-phenyl)methan oder Bis-(5-hexanoyl-2,3,4-trihydroxy-phenyl)methan ersetzt wurde.

## Patentansprüche

1. Lichtempfindliches Gemisch, das einen Naphthochinon-(1,2)-diazid-(2)-4- oder -5-sulfonsäureester eines Trihydroxyphenylketons und ein wasserunlösliches, in wässrig-alkalischen Lösungen lösliches oder mindestens quellbares harzartiges Bindemittel enthält, dadurch gekennzeichnet, dass es einen Naphthochinondiazidsulfonsäureester der allgemeinen Formel I

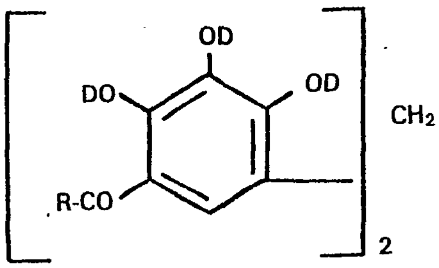

I

enthält, worin

D einen Naphthochinon-(1,2)-diazid-(2)-4-sulfonyl- oder einen Naphthochinon-(1,2)-diazid-(2)-5-sulfonylrest und

R einen gegebenenfalls durch Halogenatome oder Alkoxygruppen substituierten Alkylrest oder einen gegebenenfalls durch Alkyl- oder Alkoxygruppen oder durch Halogenatome substituierten Arylrest

bedeutet.

2. Lichtempfindliches Gemisch nach Anspruch 1, dadurch gekennzeichnet, dass es als alkalilösliches Bindemittel einen Phenolharz-Novolak enthält.

3. Lichtempfindliches Gemisch nach Anspruch 1, dadurch gekennzeichnet, dass es, bezogen auf seinen Gehalt an nichtflüchtigen Bestandteilen, 3 bis 50 Gew.-% an Verbindungen der Formel I enthält.

4. Lichtempfindliches Kopiermaterial aus einem Schichtträger und einer lichtempfindlichen Schicht, die einen Naphthochinon-(1,2)-diazid-(2)-4- oder -5-sulfonsäureester eines Trihydroxyphenylketons und ein wasserunlösliches, in wässrig-alkalischen Lösungen lösliches oder mindestens quellbares harzartiges Bindemittel enthält, dadurch gekennzeichnet, dass es einen Naphthochinondiazidsulfonsäureester der allgemeinen Formel I

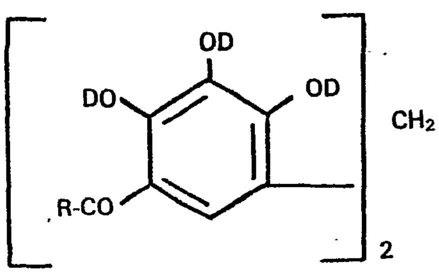

I

entspricht, worin

D einen Naphthochinon-(1,2)-diazid-(2)-4-sulfonyl- oder einen Naphthochinon-(1,2)-diazid-(2)-5-sulfonylrest und

R einen gegebenenfalls durch Halogenatome oder Alkoxygruppen substituierten Alkylrest oder einen gegebenenfalls durch Alkyl- oder Alkoxygruppen oder durch Halogenatome substituierten Arylrest

bedeutet.

5. Lichtempfindliches Kopiermaterial nach Anspruch 4, dadurch gekennzeichnet, dass der Schichtträger aus Aluminium besteht, dessen Oberfläche mechanisch oder elektrolytisch aufgerauht und anodisch oxydiert ist.

**Claims**

1. A light-sensitive mixture which contains a 1,2-naphthoquinone-2-diazide-4- or -5-sulfonic acid ester of a trihydroxyphenylketone and a water-insoluble resinous binder which is soluble or at least swellable in aqueous-alkaline solutions, characterised in that said mixture contains a naphthoquinondiazide-sulfonic acid ester of the general formula I

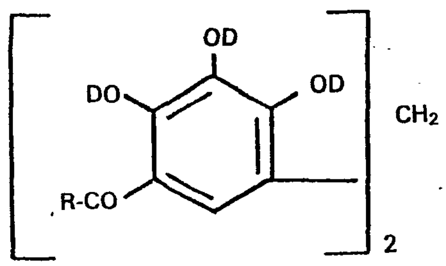

I

in which

D is a 1,2-naphthoquinone-2-diazide-4-sulfonyl or 1,2-naphthoquinone-2-diazide-5-sulfonyl radical and

R is in an alkyl radical which may be substituted by halogen atoms or alkoxy groups or an aryl radical which may be substituted by alkyl or alkoxy groups or by halogen atoms.

2. A light-sensitive mixture as claimed in claim 1, wherein the alkali-soluble binder is a phenolic resin novolak.

3. A light-sensitive mixture as claimed in claim 1, which contains 3 to 50% by weight, relative to its content of non-volatile constituents, of compounds of the formula I.

4. A light-sensitive copying material, composed of a substrate and a light-sensitive coating contains a 1,2-naphthoquinone-2-diazide-4- or -5-sulfonic acid ester of a trihydroxyphenylketone and a water-insoluble resinous binder which is soluble or at least swellable in aqueous-alkaline solutions, wherein the naphthoquinon-diazide-sulfonic acid ester corresponds to the general formula I

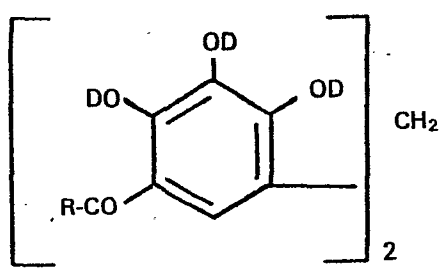

I

in which

D is a 1,2-naphthoquinone-2-diazide-4-sulfonyl or

1,2-naphthoquinone-2-diazide-5-sulfonyl radical and

R is in an alkyl radical which may be substituted by halogen atoms or alkoxy groups or an aryl radical which may be substituted by alkyl or alkoxy groups or by halogen atoms.

5. A light-sensitive copying material as claimed in claim 4, wherein the substrate is composed of aluminium, the surface of which has been mechanically or electrolytically roughened and anodically oxidized.

**Revendications**

1. Mélange sensible à la lumière, qui contient un ester d'acide naphtoquinone-(1,2)-diazide-(2)-4- ou -5-sulfonique d'une trihydroxyphénylcétone et un liant de type résine, insoluble dans l'eau, soluble ou au moins gonflable dans des solutions hydro-alcalines, caractérisé en ce qu'il contient un ester de l'acide naphtoquinonediazide sulfonique de formule générale I

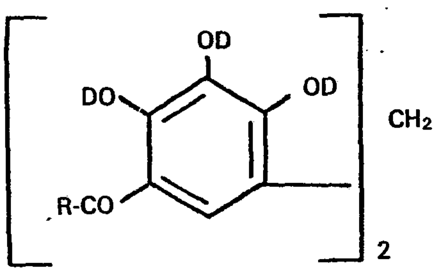

I

dans laquelle

D représente un groupe naphtoquinone-(1,2)-diazide-(2)-4- sulfonyle ou un groupe naphtoquinone-(1,2)-diazide-(2)-5- sulfonyle et

R représente un groupe alcoyle éventuellement substitué par des atomes d'halogène ou des groupes alcoxy, ou un groupe aryle éventuellement substitué par des groupes alcoyle ou alcoxy ou par des atomes d'halogène.

2. Mélange sensible à la lumière selon la revendication 1, caractérisé en ce qu'il contient comme liant soluble dans les alcalins une résine Novolaque phénolique.

3. Mélange sensible à la lumière selon la revendication 1, caractérisé en ce qu'il contient de 3 à 50% en poids de composés de formule I, par rapport au poids total de constituants non-volatils.

4. Matériau de reproduction sensible à la lumière composé d'un support de couche et d'une couche sensible à la lumière, qui contient un ester d'acide naphtoquinone-(1,2)-diazide-(2)-4- ou -5-sulfonique d'une trihydroxyphénylcétone et un liant de type résine, insoluble dans l'eau, soluble ou au moins gonflable dans des solutions hydro-alcalines, caractérisé en ce que l'ester d'acide naphthoquinone-diazide sulfonique correspond à la formule générale I

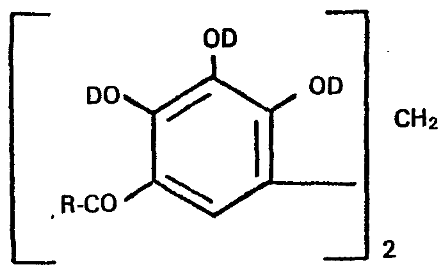

I

dans laquelle

D représente un groupe naphtoquinone-(1,2)-diazide-(2)-4- sulfonyle ou un groupe naphtoquinone-(1,2)-diazide-(2)-5- sulfonyle et

R représente un groupe alcoyle éventuellement substitué par des atomes d'halogène ou des groupes alcoxy, ou un groupe aryle éventuellement substitué par des groupes alcoyle ou alcoxy ou par des atomes d'halogène.

5. Matériau de reproduction sensible à la lumière selon la revendication 4, caractérisé en ce que le support de couche est en aluminium dont la surface est rendue rugueuse par voie mécanique ou électrochimique, et est oxidée anodiquement.